# EUROPEAN PATENT APPLICATION

(11) **EP 1 079 379 A2**
(43) Date of publication of application: **28.02.2001**
(21) Application number: 00306702.2
(22) Date of filing: 07.08.2000
(51) Int. Cl.: G11B 7/22

(54) **Optical pickup having circuit pattern formed by mid technique on main insulative base**

(30) Priority: 05.08.1999 JP 22262399
(71) Applicant: Mitsumi Electric Co., Ltd., Chofu-shi, Tokyo (JP); FCI Japan K.K., Shinagawa-ku, Tokyo (JP)
(72) Inventor: Hori, Ken'ichi c/o Mitsumi Electric Co. Limited, Atsugi-shi, Kanagawa (JP); Omote, Shoichi c/o FCI Japan K.K., Shinagawa-ku, Tokyo (JP)
(74) Representative: Moir, Michael Christopher

(57) **Abstract**

An optical pickup for use in a CD-R drive comprises a main base, photo-electrical parts including a photodiode and electrical parts mounted on the main base, and electrical wiring electrically connecting the photo-electrical parts and/or electrical parts to each other. The main base is made of plastic resin. An IC chip and other circuit elements forming an amplifier circuit for amplifying an output signal from the photodiode are connected to each other by conductor strips which are directly formed on a surface of the main base by use of the molded interconnected device (MID) technique. An electrical connector is also directly mounted on the main base and connected to the conductor strips to connect the photodiode and the amplifier circuit.

## Description

### Background of the Invention:

The present invention relates to an optical pickup for use in compact disk (CD) drive and, in particular, to an arrangement of electrical circuits on such an optical pickup of a type comprising an main base on which various kinds of optical parts, photo-electrical parts such as a laser diode and a photodiode, electrical circuits for driving the photo-electrical parts and other electrical circuits are mounted.

Generally, a computer system comprises a processor, a main memory, and storage devices as peripheral devices directly or indirectly connected to the processor. Such storage devices can be grouped into devices for handling removable media and other devices including non-removable media therein.

For example, one of the former devices is a CD-R drive which handles a CD-R (Compact Disc Recordable) as one of removable media. A CD-R is a once-writable optical disc and thus a CD-R drive can write data into a CD-R, cooperating with an applications program for the write-in. As for readout, a CD-R is compatible with a CD-ROM and an audio CD (CD-DA). Therefore, almost all of CD-R drives can read out data from not only a CD-R but also a CD-ROM and an audio CD.

In order to write data into a CD-R and read out data from the CD-R, a CD-R drive comprises an optical pickup for irradiating a light or laser beam onto the CD-R to write and read data in and out the CD-R.

In detail, an existing optical pickup comprises a laser diode for emitting a laser beam, a photodiode for sensing a light reflected from CD for reading data, an optical system for leading the emitted laser beam to a CD-R. Hard irradiation of the laser beam forms pits on a recording layer of the CD-R so that the write-in of data is carried out. Soft irradiation of the laser beam is used only for the reading the data from the CD-R. That is, the soft irradiation of the laser is directed onto the recording layer through the optical system and reflected by the recording layer, the recorded beam being applied to a photodiode through the optical system. Thus, the data stored as pits in the recording layer of the CD-R are obtained as electrical signal from the photodiode. Intensity of the hard irradiation is ten to twenty times as large as intensity of the soft irradiation. It is therefore necessary for a CD-R optical pickup to change the output level of the laser beam when the optical pickup writes in or reads out the data.

To this end, the existing optical pickup further comprises a driver for driving the laser device. The laser diode and its driving circuit are mounted on a flexible printed circuit and are electrically connected to each other through a circuit pattern. The flexible printed circuit is fixedly mounted on a main base in the existing optical pickup.

On the other hand, the photodiode is accompanied with an amplifier for amplifying the output signal from the photodiode. The amplifier is also formed in the flexible printed circuit.

Further, the optical pickup includes a lens position control mechanism or a lens actuator and a control circuit for controlling the lens position control mechanism. The control circuit is also formed on the flexible printed circuit.

Those flexible printed circuits are connected to each other through a flexible flat cable and are electrically processing circuit in the CD-R drive through a flexible flat cable.

### Summary of the Invention:

Since the laser diode, the photodiode, and a lens position control mechanism are disposed at different positions on the main base, it is complicated to locate a flexible circuit board including the flexible printed circuit boards on the optical pickup, as well as the flexible printed circuit it self is complicated in shape.

Recent requirement has been directed to reduction of size, weight and cost of optical pickup as well as other electronic devices.

To meet the requirement, it is an object of this invention to provide an optical pickup wherein a flexible circuit board including flexible printed circuit boards is simple in shape and positioning and which is thereby assembled small in size, light in weight and low in cost.

This invention is applicable to an optical pickup for use in a compact disk drive, which comprises a main base, optical parts, photo-electrical parts and electrical parts mounted on the main base, and electrical wiring electrically connecting the photo-electrical parts and/or electrical parts to each other. According to one aspect of this invention, the main base is made of plastic resin, and at least one portion of the electrical wiring is a circuit pattern of conductor strips directly formed on a surface of the main base by use of the molded interconnected device (MID) technique.

In an embodiment of this invnetion, the optical pickup includes a photosensor as one of the photo-electrical parts for detecting a light to produce an electrical output signal and an amplifier circuit connected to the photosensor for amplifying the electrical output signal. The amplifier circuit comprises an integrated circuit (IC) chip having chip terminals, other circuit elements having element terminals, and the conductor strips. The conductor strips are directly formed on the surface of the main base by the MID technique. The amplifier circuit including the IC chip and the circuit elements are directly mounted on the surface of the main base with the element terminals and the chip terminals being connected to corresponding ones of the conductor strips.

The optical pickup may further comprises an electrical connector as one of the electrical parts, the electrical connector having connection terminals. The electrical connector is mounted on the surface of the main base with the connection terminals being connected to the conductor strips so that the electrical connector is electrically connected to the amplifier circuit.

The electrical connector may preferably be a type for receiving and being electrically connected with an end of a flexible flat cable, so that the amplifier circuit is capable of electrically connected with the flexible flat cable.

The conductor strips are preferably provided with land portions corresponding to and being connected to the element terminals, chip terminals and the connection terminals, respectively.

### Brief Description of the Drawings:

Fig. 1 is a plan view showing a structure of an existing optical pickup;
Fig. 2 is a perspective view illustrating a disassembled state of the optical pickup of Fig. 1;
Fig. 3 is a diagrammatic view showing an optical relation between various optical parts in the optical pickup;
Fig. 4 is a left side view of the optical pickup of Fig. 1 with partially exploded by some parts removed;
Fig. 5 is a side view like Fig. 4 showing an main base of an optical pickup according to an embodiment of this invention;
Fig. 6 is an enlarged view of circle A depicted in Fig. 5, where patterns prior to mounting chips are shown; and
Fig. 7 is an enlarged view of circle A depicted in Fig. 5, where chips are mounted on the main base and are connected with the patterns shown in Fig. 6.

### Description of the Preferred Embodiments:

Prior to description of embodiments of this invention, brief description of an existing optical pickup relating to this invention will at first be made for a better understanding of this invention.

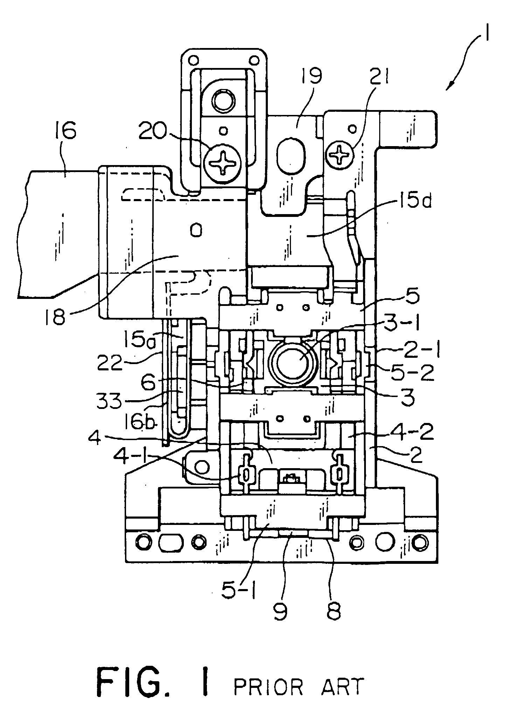

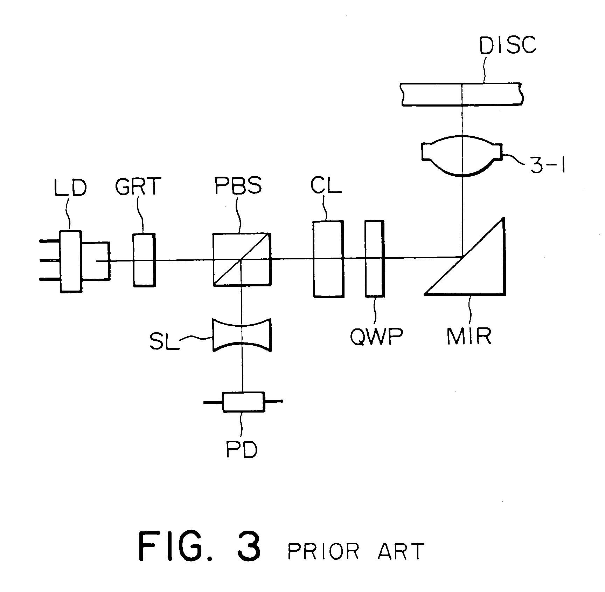

Referring to Figs. 1-3, an existing optical pickup 1 comprises a main base 2, a lens holder 3, a damper base 4, an actuator base 5, and so on. The lens holder 3 is provided with an object lens 3-1, a tracking coil 3-2 of two coil pieces connected to each other, and a focusing coil 3-3. The actuator base 5 is for accommodating the lens holder 3 and the damper base 4.

The lens holder 3 and the damper base 4 are combined with one another by a plurality of (four) suspension wires 6. In detail, two leads of the tracking coil 3-2 and two leads of the focussing coil 3-3 are connected to ends of the four suspension wires 6, respectively. Other ends of the suspension wires 6 are fixed to fixing members 4-1 formed on upper and lower sides of the damper base 4.

Two damper base covers 4-2 are attached to opposite ends of the damper base 4 to cover it. Each of the damper base cover 4-2 is made of a transparent resin material. Into a space between the damper base 4 and the damper base cover 4-2, a damping material (not shown) is loaded so as to prevent the suspension wires 6 from vibrating.

On a rear wall of the damper base 4, a flexible printed circuit board 8 is fixed and is soldered to extensions of the suspension wires 6. Therfore, the tracking coil 3-2 and thefocussing coil 3-3 are electrically connected to the flexible printed circuit board 8 through the suspension wires 6. Thus, the lens holder 3 and the damper base 4 are combined with each other by a plurality of suspension wires 6 to form a preassemly. Then, the preassembly is accommodated into and fixed to the actuator base 5.

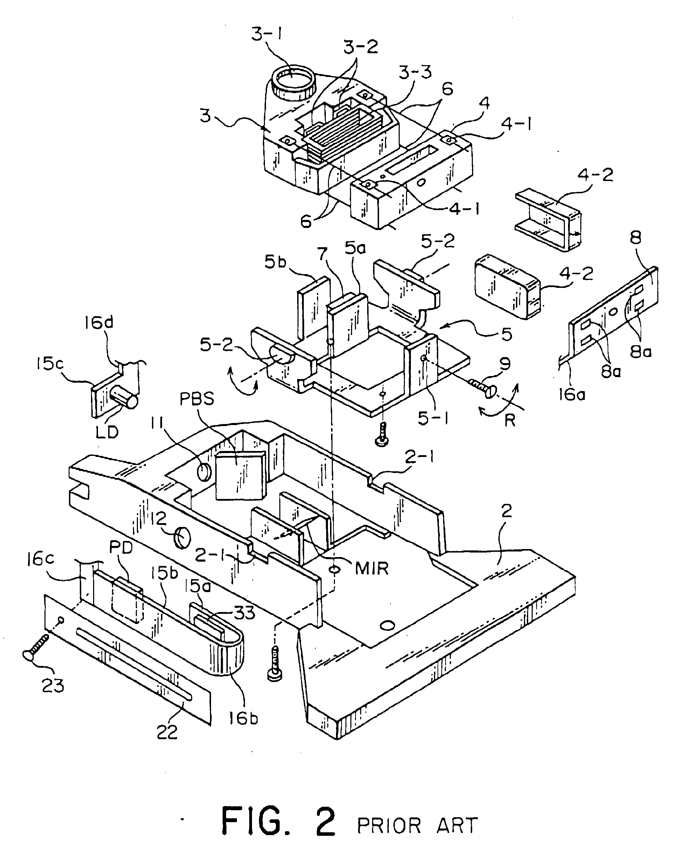

The actuator base 5 has a frame-like molded body, which may be made of a metal material or any other suitable material. The actuator base 5 is provided with an acceptor (not shown) on a part of the actuator base 5. This acceptor comprises a supporting block 5-1 for fixing the damper base 4. The damper base 4 is fixed together with the flexible printed circuit board 8 to the supporting block 5-1 by use of a screw 9, so that the damper base 4 can rotate around the screw 9 as shown by an arrow R in Fig. 2. This structure is employed for the skew adjustment.

The actuator base 5 has magnetic yoke portions 5a and 5b, one 5a of which is attached with a permanent magnet 7. The magnetic yoke portions 5a and 5b and permanent magnet 7 form a lens position control mechanism or a lens actuator together with the tracking coils 3-2 and focussing coil 3-3 for finely controlling the position of object lens 3-1 in relation to a CD-R disk.

Moreover, the actuator base 5 has projections 5-2 in a semi-circular shape on both side walls of the frame-like body thereof. The projections 5-2 are supported by support portions 2-1 formed in opposite side walls of the main base 2.

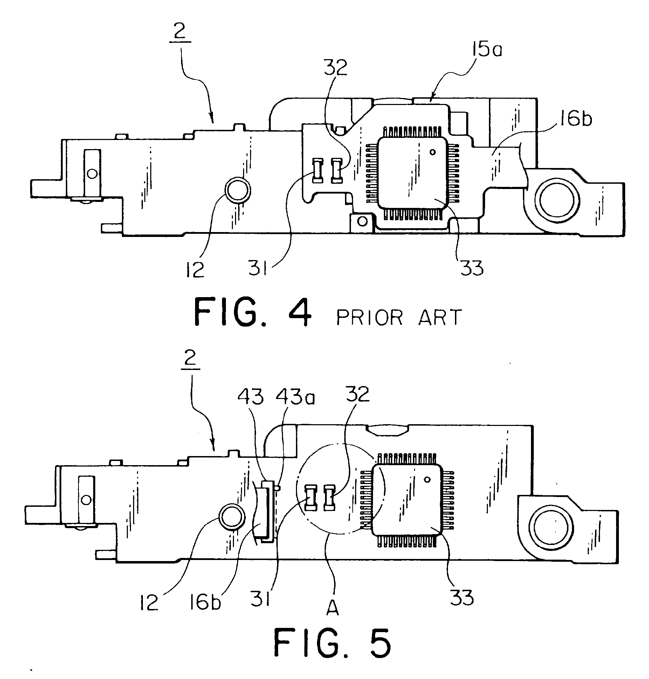

The optical pickup 1 has an optical system which is schematically shown in Figs. 4. The illustrated optical system comprises a laser diode LD as a laser device, a diffraction grating GRT, a polarizing beam splitter PBS, a collimator lens CL, a 1/4 wavelength plate QWP, a mirror MIR, an object lens 3-1, an optical disc DISC, a sensor lens SL, and a photodiode PD as a photosensor. In Fig. 4, the laser diode LD, the diffraction grating GRT, the polarizing beam splitter PBS, the collimator lens CL, the 1/4 wavelength plate QWP, the mirror MIR, the sensor lens SL, and the photodiode PD all are arranged on a horizontal plane, while the object lens 3-1 and the optical disc DISC are positioned above the mirror MIR.

The polarizing beam splitter PBS, the mirror MIR and the object lens 3-1 are also shown in Fig. 2. In the figure, the laser diode LD is disposed in a laser setting hole 11 formed in an end wall of the main base 2, while the photodiode PD is arranged and facing to a sensor setting hole 12 formed in a side wall of the main base 2.

When the laser diode LD horizontally emits a laser beam, the diffraction grating GRT separates the laser beam into three laser beams. The three laser beams pass through the polarizing beam splitter PBS, the collimator lens CL, and the 1/4 wavelength plate, and go toward the mirror MIR in the horizontal plane. The mirror MIR reflects the laser beams with a right angle and directs the laser beams toward the object lens 3-1. Thus the laser beams go upward in the vertical direction and pass through the object lens 3-1. Thereby, the laser beams are irradiated onto the optical disc DISC.

The laser beams are reflected by the optical disc DISC to be reflected light. The reflected light goes downward in the vertical direction and passes through the object lens 3-1. The light is shifted at a right angle by the mirror MIR and goes towards the 1/4 wavelength plate QWP in the horizontal plane. The lights passes though the 1/4 wavelength plate QWP and the collimator lens CL. The light is shifted at a right angle by the polarizing beam splitter PBS again, and goes toward the sensor lens SL in the horizontal plane. Through the sensor lens SL, the light is detected by the photodiode PD.

In the existing optical pickup, a discrete printed circuit such as the flexible printed circuit board and flexible flat cable is required for mounting a drive circuit for the laser diode, an amplifier circuit for an output signal detected by the photodiode, a feeding line for feeding control current to the tracking coil 3-2 and the focussing coil 3-3 through suspension wires 6, and connecting lines for electrically connecting the pickup with a circuit in the CD-R drive. Flexible printed circuit (FPC) portions are shown at 8, 15a, 15b, 15c, and 15d, and flexible flat cable (FFC) portions are shown at 16, 16a, 16b, 16c, and 16d in Figs. 1, 2, and 4. On FPC portion 8, there are four lands 8a which are soldered to the extensions of the suspension wires 6, respectively. The FPC portion 8 is connected to FFC portion 16 through FFC portion 16a. On FPC portion 15a fixed on a side wall of the main base 2 by use of screws or other means, there are mounted resistors (31, 32 in Fig. 4) and an amplifier IC chip 33. The FPC portion 15a is connected through FFC portion 16b to FPC portion 15b on which the photodiode PD is mounted. The FPC portion 15b is also connected to FFC portion 16 through FFC portion 16c. The laser diode LD and its driver circuit are mounted on FPC portions 15c and 15d which are connected together through FFC portion 16d. The FPC portion 15d is connected to FFC portion 16. The FFC portion 16 is connected to the circuit in CD-R drive.

Referring to Fig. 1, FFC portions 16, 16a and 16c are partially covered with a cover plate 18 and FFC portion 16d is covered with another cover plate 19, both cover plates 18 and 19 being fixed to main base 2 by screws 20 and 21, respectively. FFC portion 16a extends under the actuator base 5. Thus, those FFC portions 16, 16a, 16c and 16d are stationarily held on the main base 2. Those cover plates 18 and 19 are not shown in Fig. 2.

FFC portion 16b is turned over FPC 15a and extends along the side surface of the main base 2 to locate FPC portion 15b in front of the sensor setting hole 12. Thus, the photodiode PD is disposed to face the sensor setting hole 12. In order to prevent the FFC portion 16b and the FPC portion 15b from laterally protruding away from the main base 2, a side cover 22 is overlapped on the FFC portion 16b and the FPC 15b and is fixed to the side wall of the main base 2 by a screw 23.

In the existing optical pickup, a flexible circuit piece including FPC portions 8, 15a-15d and FFC portions 16-16s is complicated in shape and in wiring on the main base. Further, various cover plates must be attached by use of screws to the main base 2 so as to hold the flexible circuit piece stationarily.

Now, an embodiment of the present invention will be described in detail with reference to Figs. 5-7. Since the embodiment is similar to the existing optical pickup in a general structure, a difference will be shown in the figures and described below.

Referring to Fig. 5-7, an optical pickup according to the embodiment of this invention comprises a main base 2 to which the MID techniques are applied.

Specifically, the main base 2 is mainly made of an insulator, preferably, plastic resin material. In the present embodiment, the plastic resin material is LCP (liquid crystal polymer), but may be any other suitable plastic resin material. For example, super engineering plastics such as PES (polyether sulfon), PEI(polyether imide), and PPS (polyphenylene sulfide), and thermosetting resins such as epoxy, may be used as the plastic resin material.

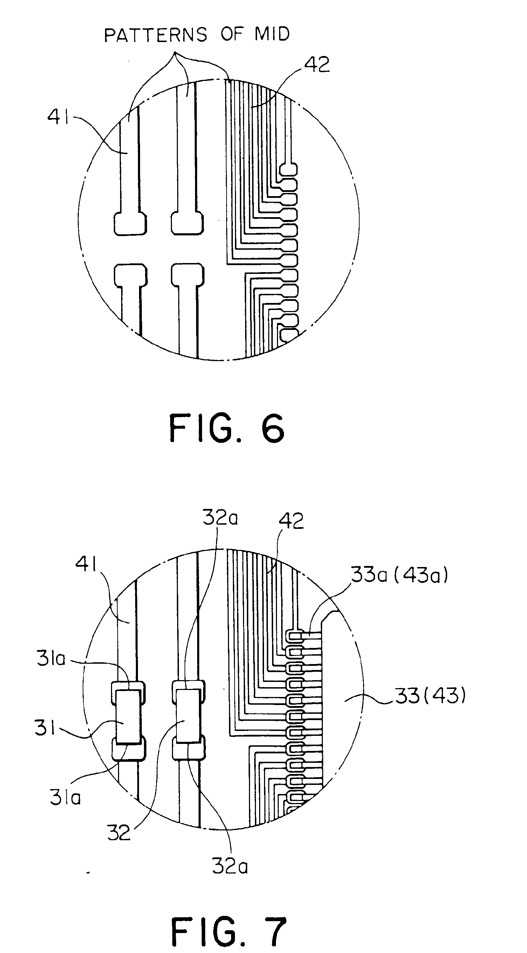

On a surface of a side wall 2-2 of the main base 2, an amplifier circuit including resisters 31 and 32 and an amplifier IC chip 33, which has been formed on the FPC (15a in Fig. 4) in the prior art, is directly formed together with a FFC connector 43 directly mounted on the side wall 2-2. In detail, a circuit pattern including a plurality of conductor strips 41 and 42 is directly formed on the surface of the side wall 2-2 as shown in Fig. 6 by using the MID techniques. Herein, the conductor strips 41 and 42 may be formed by plating with copper, gold, nickel, and the like.

The resistors 31 and 32 and IC chip 33 are mounted on the side wall 2-2 with their terminals that is, element terminals 31 a and 32a and chip terminals 33a being soldered to corresponding land portions of conductor strips 41 and 42, as shown in Fig. 7: The FFC connector 43 is also mounted on the side wall 2-2 with its terminals 43a being connected to corresponding land portions of conductor strips 42 in the similar manner as IC chip 33. Therefore, the reference numbers 43 and 43a representing the FFC connector and its terminals are shown with parenthesis adjacent to reference numerals 33 and 33a representing the IC chip in Fig. 7, without independently illustrating connection between the connector terminals 43a and the corresponding conductor strips for the purpose of simplification of the drawings.

The FFC connector 43 is used for electrical connection of the amplifier circuit directly mounted on the side wall 2-2 with an FFC portion 16b connected to an FPC portion having the other electrical circuit such as 15b in Fig. 2.

The main base 2 with the conductor strips 41 and 42 is, for example, manufactured by following steps.

First, a resin material is molded into an original form of the main base 2 as a molded product. The molded product is etched on and added catalyst to, and then the whole body is subjected to electroless-plating. A surface of side wall 2-2 of the molded product 2 on which a circuit pattern will be formed is subjected to electroplating with a conductive material such as copper, and thereby a conductive film is formed on the surface. By patterning the conductive film according to the following patterning process, a desired circuit pattern is formed on the surface of the main base 2.

In order to pattern the conductive film, a resist film for plating is at first deposited on the conductive film. Then, the circuit pattern is drawn on the resist film for plating, by using a laser beam. As the result, the resist film for plating has a shape of a negative pattern of the circuit pattern. In this condition, plating materials are electroplated so as to form the circuit pattern. The plating materials may be nickel, solder, gold, and so on. The resist film for plating is then removed and conductive material is subjected to etching, by using the plating materials as etching resists. Thus the circuit pattern is formed on the main base 2.

After forming the desired circuit pattern as mentioned above, the electrical parts are mounted on predetermined positions on the circuit pattern, and thereby, the main base 2 shown in Fig. 5 is obtained. The circuit pattern is not shown in the figure for the purpose of simplification of the drawing.

Comparing the embodiment shown in Figs. 5-7 with the existing optical pickup in Figs. 1-4, the former is not provided with the FPC portion 15a and FFC portion 16b turned in the latter. Therefore, the former is not necessary of the cover plate 22. This results in simplification of assembling operation of the optical pickup.

In another embodiment, another circuit pattern of conductor strips may be formed to extend on an inner surface of a bottom of the main base 2 by the MID technique, in place of a part of the FFC portion 16a which is extending under the actuator base 5 for connecting the FFC portion 16 and FPC portion 8 shown in Fig. 2. In the embodiment, two connectors are also mounted on the bottom of the main base and connected to the conductor strips. The FPC portion 8 and the FFC portion 16 are coupled with the two connectors, respectively, so that the FPC portion 8 and the FFC portion 16 are electrically connected to each other through the conductor strips formed on the bottom of the main base 2. The operation for assembling of the actuator base 2 together with the lens holder 3 and damper base 4 having FPC portion 8 onto the main base 2 is simplified.

As will readily be understood by reference with the above mentioned embodiments, it is possible according to the embodiment of this invention to form the optical pickup which has conductor strips directly formed on the main base for electrically connecting electrical and electro-optical parts to each other without a flexible printed circuit and flexible flat cable.

Compared with the existing optical pickup, the manufacturing process and the wiring process on the main base relating to a flexible printed circuit and flexible flat cable can be simplified. Therefore, the optical pickup according to this invention can be lighter in weight, easy in assembling operation, and lower in cost compared with the existing optical pickup.

While the invention has been described in terms of a preferred embodiment, those skilled in the art will recognize that the invention can be practiced with modification within the spirit and scope of the appended claims. In the above-mentioned manufacturing processes according to the embodiment of this invention, the process relating to the MID manufacture is called the direct lithography method. However, this invention should not be restricted to this method, and other MID manufacturing techniques may be used for the production. For example, the direct lithography method may be substituted by a method of putting a photomask above a molded product and carrying out ultraviolet lithography. Also, the direct lithography method may be substituted by a method of transferring circuit patterns on the molded product by using a film having the circuit patters, or a method of molding circuit parts and non-circuit parts by conducting the two-colour molding and forming the circuits by the use of plating.

Each feature disclosed in this specification (which term includes the claims) and/or shown in the drawings may be incorporated in the invention independently of other disclosed and/or illustrated features.

Statements in this specification of the "objects of the invention" relate to preferred embodiments of the invention, but not necessarily to all embodiments of the invention falling within the claims.

The description of the invention with reference to the drawings is by way of example only.

The text of the abstract filed herewith is repeated here as part of the specification.

An optical pickup for use in CD-R drive comprises a main base, photo-electrical parts including a photodiode and electrical parts mounted on the main base, and electrical wiring electrically connecting the photo-electrical parts and/or electrical parts to each other. The main base is made of plastic resin. An IC chip and other circuit elements forming an amplifier circuit for amplifying an output signal from the photodiode are connected to each other by conductor strips which are directly formed on a surface of the main base by use of the molded interconnected device (MID) technique. An electrical connector is also directly mounted on the main base and connected to the conductor strips to connect the photodiode and the amplifier circuit.

## Claims

1. An optical pickup for use in a compact disk drive, which comprises a main base, optical parts, photo-electrical parts and electrical parts mounted on said main base, and electrical wiring electrically connecting said photo-electrical parts and/or electrical parts to each other, wherein said main base is made of electrically insulating plastics material, and at least one portion of said electrical wiring is a circuit pattern of conductor strips formed on a surface of said main base by use of the molded interconnected device (MID) technique.

2. An optical pickup as claimed in claim 1, including a photosensor as one of said photo-elctrical parts for detecting a light to produce an electrical output signal and an amplifier circuit connected to said photosensor for amplifying said electrical output signal, said amplifier circuit comprising an integrated circuit (IC) chip having chip terminals, other circuit elements having element terminals, and said conductor strips formed on said surface of said main base, wherein said amplifier circuit including said IC chip and said circuit elements are mounted on said surface of said main base with said element terminals and said chip terminals being connected to corresponding ones of said conductor strips.

3. An optical pickup as claimed in claim 2, further comprising an electrical connector as one of said electrical parts, said electrical connector having connection terminals, wherein said electrical connector is mounted on said surface of said main base with said connection terminals being connected to said conductor strips so that said electrical connector is electrically connected to said amplifier circuit.

4. An optical pickup as claimed in claim 3, wherein said electrical connector is a type for receiving and being electrically connected with an end of a flexible flat cable, so that said amplifier circuit is capable of electrically connected with said flexible flat cable.

5. An optical pickup as claimed in claim 3, wherein said conductor strips are provided with land portions corresponding to and being connected to said element terminals, chip terminals and said connection terminals, respectively.

6. An optical pickup as claimed in claim 1, wherein said plastics material is one selected from a group consisting of LCP (liquid crystal polymer), PES (polyether sulfone), PEI (polyether imide), and PPS (polyphenylene sulfide).

7. An optical pickup as claimed in claim 1, wherein said plastics material is a thermosetting resin.

8. An optical pickup as claimed in claim 7, wherein said thermosetting resin is an epoxy resin.
